# EUROPEAN PATENT APPLICATION

(11) **EP 1 763 086 A1**
(43) Date of publication of application: **14.03.2007**
(21) Application number: 05447200.6
(22) Date of filing: 09.09.2005
(51) Int. Cl.: H01L 31/0216, H01L 31/0224, H01L 31/18, H01L 31/02

(54) **Photovoltaic cell with thick silicon oxide and silicon nitride passivation and fabrication method**

(71) Applicant: Interuniversitair Micro-Elektronica Centrum, 3001 Leuven (BE)
(72) Inventor: Agostinelli, Guido, B-1060 Brussel (BE); Beaucarne, Guy, 3050 Oud-Heverlee (BE); Choulat, Patrick, 562060 Larmor-Plage (FR)
(74) Representative: Bird, William Edward

(57) **Abstract**

A method for the production of a solar cell is disclosed , comprising the steps of providing a silicon substrate having a front main surface and a back main surface; depositing a dielectric layer on the back main surface; depositing a passivation layer comprising hydrogenated SiN on top of the dielectric layer; forming holes in the dielectric layer and the SiN:H layer; depositing a layer of contacting material onto the dielectric layer, hereby filling, the holes; and applying a high temperature step.

Furthermore a solar cell device is disclosed comprising a silicon substrate having a front main surface and a back main surface; a dielectric layer on the back main surface; a passivation layer comprising hydrogenated SiN on top of the dielectric layer; holes through the dielectric layer and theSiN:H layer; and layer of contacting material onto the dielectric layer, the layer also filling the holes.

## Description

### Field of the invention

The present invention relates to the field of photovoltaics.

### Background of the invention

Significant cost reduction of bulk crystalline silicon solar cells requires the removal of the technological barriers that impede the development of a high throughput, low cost, and reliable industrial process on thin substrates. Present industrial surface conditioning and rear surface passivation processes do not meet the requirements for yield and performance on thin substrates. A well-established process step such as the full area, screen printed Al-Alloyed BSF is to be abandoned, due to insufficient performance and excessive warping of the wafers below 200µm. There exist a variety of solutions for laboratory scale production, but these are not applicable to commercial quality material, nor would guarantee cost effectiveness and throughput.

The major problem is that of passivating the rear surface and, at the same time, providing (local) electrical contacts of an ohmic nature and a limited surface recombination velocity to the base.

Engineering a dielectric with surface passivation properties that are resistant to contact firing with a process that is not harmful to the bulk lifetime of commercial quality materials (e.g. Cz-Si, mc-Si), and that does not interact with the rear side metallisation is all but a trivial task. Most dielectrics lose their passivation properties during the rapid thermal treatment, which is necessary to fire the front contacts through the ARC, and it is known that interaction between the rear side aluminum and the dielectric can jeopardize the cell efficiency, despite excellent results of surface passivation on bifacial samples reported in literature for a variety of dielectric layers on silicon. Nor is it trivial to integrate such layer in a complete solar cell process sequence, given the repeated high temperature treatments and cleaning/etching steps that need to be carried out in a given sequence.

In "Effective passivation of the low resistivity silicon surface by a rapid thermal oxide/plasma silicon nitride stack", Applied Physics Letters, Volume 72, Number 15, 13 April 1998, a passivation process is described for a low resistivity silicon surface. A rapid thermal oxide (RTO) is deposited by rapid thermal processing (RTP) at 900° for 5 minutes, followed by the deposition of a SiN layer by Plasma Enhanced Chemical Vapour Deposition process (PECVD). An effect is shown of the RTO temperature on the passivation of the stack. The RTO layer is about 7.9 nm thick. No photovoltaic cell production process is performed. No solar cell rear surface passivation process is performed nor analysed.

In "The effect of Low and High Temperature Anneals on the Hydrogen Content and Passivation of Si Surface with SiO2 and SiN Films", Journal of The Electrochemical Society, 146 (5) 1921-1924 (1999) different Si surface passivation schemes are investigated and compared. It is suggested that the release of hydrogen from SiN during the anneal further passivates the RTO/Si interface underneath. The examples comprise thin oxide layers of about 10nm. For low quality oxides a lower passivation property is indicated. No solar cell production process is performed nor analysed.
In "Investigation of various surface passivation layers using oxide/nitride stacks of silicon solar cells", Lee, J. Y.; Dicker, J.; Rein, S.; Glunz, S.W.; Proceedings of 3rd World Conference on Photovoltaic Energy Conversion, Osaka 2003, 12-16 May 2003, p1069 - p1072 Vol.2, different surface passivation processes based on Classical Thermal Oxidation (CTO), RTO, SiNx and oxide/nitride stacks are tested and introduced in solar cells. It is concluded that a) oxide/nitride stack passivation relies on a combined native low density of interface states at the SiO₂/Si interface and high fixed charge density at the SiNx/SiO₂ interface and b) that nevertheless oxide/nitride stacks have a weak front and rear surface passivation when introduced in solar cells. Point a) suggests that for passivation to be effective,
- the oxide/silicon interface shall be natively of a good quality.
- The oxide shall be as thin as possible, because the thinner the oxide, the stronger the field effect passivation due to the nitride charges.

### Aim of the invention

It is an aim of this invention to provide for a method for producing a photovoltaic cell, which alleviates or avoids some problems of the prior art and reduces the production cost.

### Summary of the invention

In a first aspect of the present invention a method for the production of a photovoltaic device as for instance a solar cell is disclosed, comprising the steps of:
1. providing a silicon substrate or silicon layer or a silicon thin film having a front main surface and a back main surface
2. depositing a dielectric layer on the back main surface
3. depositing a passivation layer comprising hydrogenated SiN on top of the dielectric layer.
4. forming holes in the dielectric layer and the SiN:H layer
5. depositing a layer of contacting material onto the dielectric layer, hereby filling the holes.
6. Applying a high temperature step.

Any silicon substrate may be used. Some Examples of silicon substrates are Czochralski Si wafers, Float-Zone Si wafers, multicrystalline Si wafers and Ribbon Si wafers.

Some examples of layers are polycrystalline silicon layers which can be put on glass or glass-ceramic, or monocrystalline Si layers obtained by a lift-off process

In certain embodiments the dielectric layer is a low quality dielectric layer or a low quality oxide.

In certain embodiments the dielectric layer comprises low quality amorphous oxide, which can reduce production costs when compared to high quality oxide.

In certain embodiments the dielectric layer comprises low quality amorphous silicon oxide, which can reduce production costs when compared to high quality silicon dioxide.

In certain embodiments the dielectric layer is a deposited dielectric layer. Deposited dielectric layers are typically of lower quality then grown dielectric layers.

In certain embodiments the dielectric layer is deposited by APCVD (atmospheric pressure CVD).

In certain embodiments the production rate (which can be growth rate or deposition rate) of the dielectric layer, expressed in layer thickness per minute (min), is higher than 5 nm, or higher than 10, or higher than 20, or higher than 30, or higher than 50 nm per min.

A grown silicon dioxide is formed as the product of a reaction between the Si of the substrate and oxygen provided through the gas phase. In the case of a deposited oxide or dielectric none of the reagents comes from the substrate or the silicon layer.

The low-quality amorphous oxide can for instance be a Spin-on oxide or APCVD pyrolithic oxide (pyrox), spin-on, spray-on or dip oxide.... It can be for instance a silicon oxide, TiO2 (e.g. deposited by solgel), or Al2O3/TiO2 pseudobinary alloys (PBAs).

In advantageous embodiments a dielectric layer is deposited which has a thickness between 40 and 1500 nm. In certain embodiments, the minimal thickness depends on the material which is employed and is determined by the amount of material which is necessary to act simultaneously as a diffusion mask during emitter diffusion, and be still of use for surface passivation and contact formation,

For pyrox SiOx this is typically about 300nm, For TiO2 deposited by solgel this is about 50nm, for Al2O3/TiO2 pseudobinary alloys (PBAs) deposited by solgel this is about 150nm. Those thickness values are only indicative and a deviation of 10%, 20% or more from the given values is possible. Also a combination, or a stack of layers, of different materials are possible and would lead to a certain threshold thickness for the combined diffusion mask, surface passivation and contact formation process.

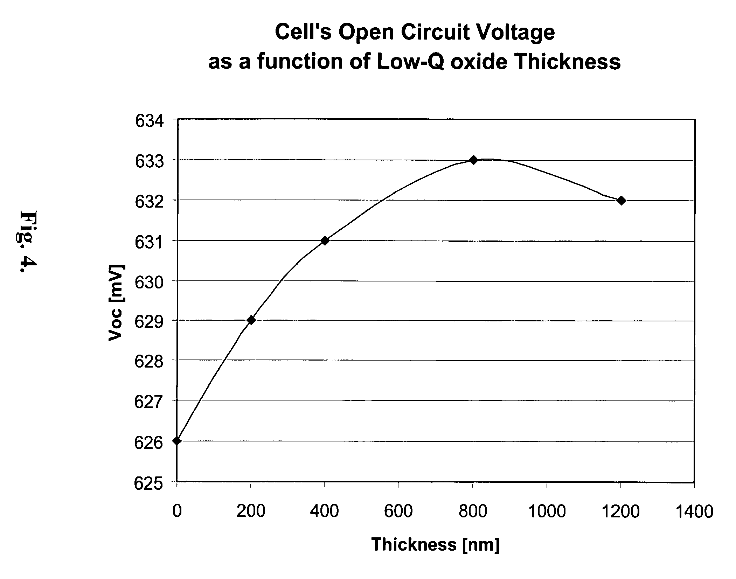

In certain embodiments the dielectric layer has a thickness between 600 and 1200 nm or between 800 and 1200 nm. This is illustrated in Fig.4.

Depositing the dielectric at certain temperatures brings certain advantageous effects, some of which are described below:

In certain embodiments the deposition temperature is < 600°C, hereby allowing processing without thermal poisoning of substrates In certain embodiments the dielectric is deposited by PECVD at a temperature < 500°C.
- in certain embodiment the depositing temperature < 410°C, which can be achieved by using for instance pyrox (a typical deposition temperature: 404°C) In certain embodiments the dielectric is deposited by low temperature PEVCD (< 300°C).

In certain embodiments the deposition is done at Room Temperature e.g. by spin-on, spray-on, dip or any other deposition from liquid, sol, solgel. It may need further curing at higher temperatures, which can happen during further cell processing. In certain embodiments the high temperature step is a contact firing step and is performed at a temperature, or higher than 730, up to 960 degrees, for maximum about a few tens of seconds. The firing step can be "co-firing" when the front and rear side contact are created at the same time. When this is decoupled, the rear side can be fired above 800 degrees, and subsequently the front contact can be fired around 750 degrees (and possibly followed by a forming gas anneal -FGA-) The numbers in the last paragraph are indicative but certain variations are possible (e.g. of about 25%).

The step of forming holes can for instance be performed by applying an etching paste, mechanical scribing or by laser ablation.

The step of depositing a layer of contacting material can for instance be performed by evaporation, sputtering, or screen printing, inkjet printing, stencil printing.

Metals can be used as contacting materials, although advantageously Aluminum can be used. The present invention offers advantages when using Aluminum paste, allowing the formation of local BSF contacts. Alternatively, after depositing the passivation layer, firing it, one could deposit, instead of a metal, a p+ (or n+ on n-type substrates) semiconductor (like a-Si) by e.g. PECVD and then depositing a metal on top of it.

In certain embodiments according to the present invention, when it is not possible to use the passivation layer as a diffusion mask, a further step can be comprised of diffusion with another mask to be etched off, or maskless diffusion with subsequent rear side parasitic emitter removal before depositing the dielectric layer.

In advantageous embodiments according to the present invention the dielectric layer can be used simultaneously as a diffusion mask and for the purpose of surface passivation, thereby simplifying the cell process sequence.

In certain embodiments the layer of contacting material is initially discontinuous. This means that different area can be covered with contacting material, whereby those different areas are mot connected to each other. These areas can be electrically connected later on in order to allow an optimal current flow through the device and/or an external load.

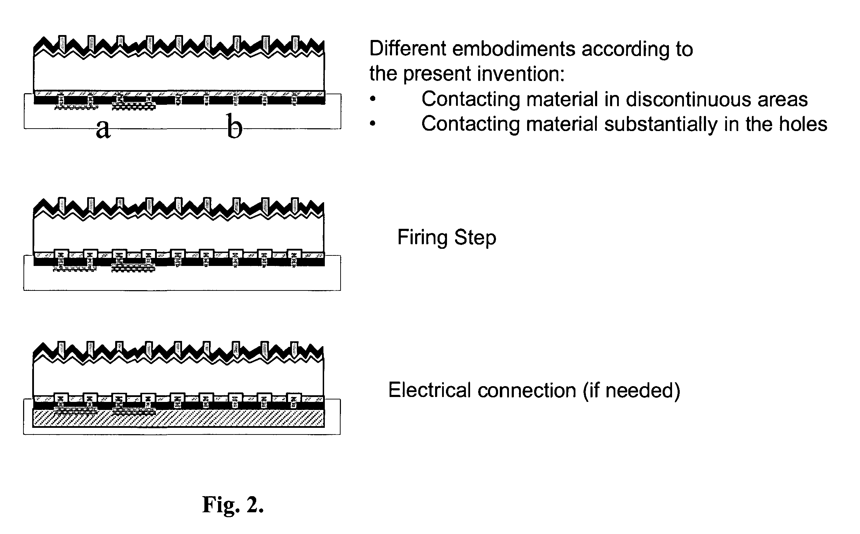

In a specific example of a discontinuous layer of contacting material, the contacting material can be present essentially in the holes. Different ways of depositing such a discontinuous layer of contact material exist, and are known by a person of ordinary skill. (cfr e.g. Fig. 2)

In certain embodiments the layer of contacting material is deposited in such way that light can also enter the device from the rear side, thereby allowing the production of bifacial solar cells.

In certain embodiments the front main surface has undergone a typical solar cell front surface processing. A typical solar cell front surface process comprises texturing of the front surface, diffusion of phosphorus atoms at the front side, etching of the phosphorus glass and the deposition of a silicon nitride layer on the front side.

The method according to the present invention provides additional advantages when the silicon substrate is an ultra-thin substrate, which is typically thinner then 250 microns, or thinner than 200 or 150 microns.

Ultra-thin substrates may bow under/after certain treatments, and the present invention improved the resistance against bowing of such thin substrates, therefore reducing at least some of the difficulties of the use of ultra thin substrates for solar cell fabrication.

In another aspect of the present invention a photovoltaic device as for instance a solar cell device is disclosed, corresponding to the methods of the first aspect of the invention. Other photovoltaic devices are possible as for instance radiation detectors. It should be understood that motivations, variations, alternative embodiments, limitations, etc which are explained in the context of the method, also apply to the device according to the present invention.

A photovoltaic device as for instance a solar cell device is disclosed comprising
1. a silicon substrate or silicon layer or silicon thin film having a front main surface and a back main surface
2. a dielectric layer on the back main surface
3. a passivation layer comprising hydrogenated SiN on top of the dielectric layer
4. holes through the dielectric layer and the SiN:H layer
5. layer of contacting material onto the dielectric layer, the layer also filling the holes.

Any silicon substrate may be used. Some Examples of silicon substrates are Czochralski Si wafers, Float-Zone Si wafers, multicrystalline Si wafers and Ribbon Si wafers.

Some examples of layers are polycrystalline silicon layers, which can be put on glass or glass-ceramic, or mono crystalline Silicon layers obtained by a lift-off process

In certain embodiments the dielectric layer comprises a low quality dielectric or a low quality oxide.

In certain embodiments the dielectric layer comprises a low quality amorphous oxide.

In certain embodiments the dielectric layer comprises low quality amorphous silicon oxide.

In certain embodiments the dielectric layer is a deposited dielectric layer. Deposited dielectric layers are typically of lower quality then grown dielectric layers.

The low-quality amorphous oxide can for instance be a Spin-on oxide or APCVD (Atmospheric pressure) pyrolithic oxide, spin-on, spray-on or dip oxide.... It can be for instance a silicon oxide, TiO2 (e.g. deposited by solgel), or Al2O3/TiO2 pseudobinary alloys (PBAs).
In advantageous embodiments the dielectric layer has a thickness between 40 and 1500 nm. In certain embodiments, the minimal thickness depends on the material which is employed and is determined by the amount of material which is necessary to act simultaneously as a diffusion mask during emitter diffusion, and be still of use for surface passivation and contact formation.
For pyrox SiOx this is typically about 300nm, For TiO2 deposited by solgel this is about 50nm, for Al2O3/TiO2 pseudobinary alloys (PBAs) deposited by solgel this is about 150nm. Those thickness values are only indicative and a deviation of 10%, 20% or more from the given values is possible.
In certain embodiments the dielectric layer has a thickness between 600 and 1200 nm or between 800 and 1200 nm. This is illustrated in Fig.4.

A low-quality amorphous oxide presents several advantages with respect to high quality, grown oxides, in that it can e.g. be cheaper and less harmful to the lifetime of the bulk material.

In certain embodiments the layer of contacting material is discontinuous. This means that different area can be covered with contacting material, whereby those different areas are not connected to each other.
In an advantageous example of a discontinuous layer of contacting material, the contacting material can be present essentially in the holes.
In certain embodiments the device according to the present invention is bifacial.
In certain embodiment the front main surface comprises a typical solar cell front surface.

In certain advantageous embodiments the substrate has a thickness smaller then 250 microns or smaller then 200 or 150 microns.
It has been shown that working solar cells down to 90µm thickness can be produced (efficiencies of 11% have been easily achieved) with the invention without showing any bowing problem despite the use of screen printed Al paste for contacting on the full rear side.

It should be noted that some layers formed or produced, grown or deposited by a certain technique can successfully afterwards be investigated to retrieve their formation technique. An example of such a technique is for instance the inspection of TEM (Tunnelling electron microscopy) pictures, but other techniques can be used, which are known to a person skilled in the art.
The method according to the present invention can be applied in the field of back contacted solar cells. This would result in a back contacted solar cell, which can further comprise features of the devices according to the present invention.

### Description of the figures

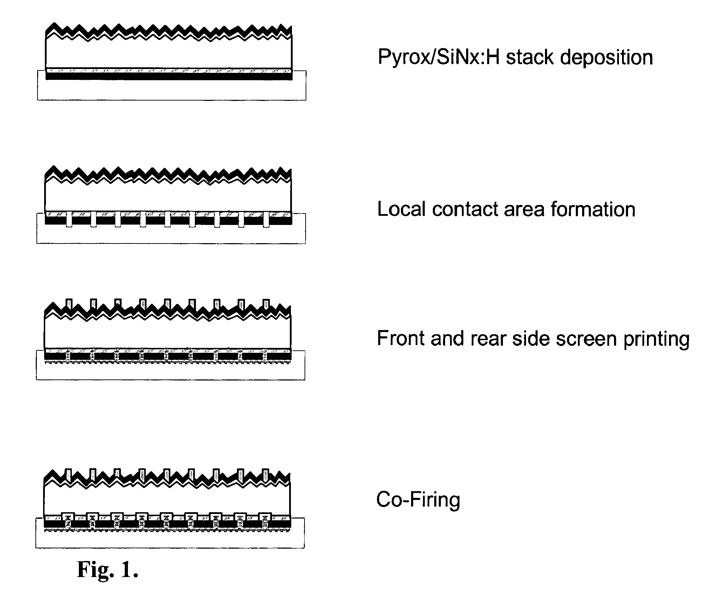

Fig. 1. Example of a photovoltaic device as e.g. a solar cell fabrication process according to the present invention.
Fig.2. Illustration of embodiments according to the present invention.
Fig. 3. Effective lifetime of a group of bifacial Cz silicon wafers after different passivation and thermal treatments. The samples are measured at an injection level of 10¹⁴ excess carriers/cm3. It is shown that deposition and firing of hydrogenated SiNx are beneficial to the layer on both as deposited and thermally treated/diffused (cycle in POCI3 diffusion furnace) samples.
Fig. 4. The open circuit voltage of the cell, a figure of merit parameter that correlates directly to the quality of the rear side passivation layer, is shown as a function of the thickness of the deposited low quality oxide.

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes.

Furthermore, the terms first, second, third and the like in the description and in the claims, are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

In the embodiments of the present invention, for instance more than 10 nm, 40nm, 100nm, 200nm, 800nm of Oxide are deposited on the silicon surface. On top of it a layer of SiNx:H optimized for hydrogen release is deposited. The silicon surface passivation is improved by means of hydrogenation.

A rear side passivation layer has been developed that (a) retains or improves, its surface passivation qualities during the firing step, that (b) cannot be fired through by commercial Aluminum screen printed paste, while there exists a least-damage, fast technique to locally remove such layer prior to metallisation and that. (c) does not interact with the capping metal layer during the firing process or when local contacts are otherwise formed through it.

Due to its characteristics this process
- provides an efficient surface passivation, where
- it is possible to make local (BSF) contacts, and
- eliminates the bowing problems when using ultra thin wafers or substrates (e.g. problems when combined with Al screen printed paste on ultra thin wafers).

A generic low quality amorphous Oxide was deposited (e.g. SiO2, SiOx, SOG, TiO2, AI2O3... or their pseudo-alloys, SiONx,) on the solar cell's rear side silicon surface (e.g. by APCVD, or spin coating) and its surface passivation properties were improved by depositing an optimized hydrogenated dielectric layer (namely: SiNx:H). Such stacks retain the passivation properties during short high temperature treatments. The passivation properties are even improved during this treatment. This feature is important as it enables the use of the contact co-firing process that takes place in most of the industrial silicon solar cells' process sequence. Moreover, given that a) it is resistant to firing; i.e. it doesn't lose its relevant characteristics b) it cannot be fired through but c) it is possible to create local openings or holes in it by techniques such as e.g. etching paste or laser ablation, this invention enables for an easy way to create Local Back Surface Field (LBSF) contacts by selective alloying, during the firing process itself. The alloying process partially recovers any surface damage that may have incurred during the opening of the layer, thereby further simplifying the process. During the alloying, part of the Si surface and subsurface forms an alloy with the metal. The surface termination is therefore not crucial, as it would be e.g. when depositing another semiconductor, or a dielectric. A back surface field is formed and the effect of residual subsurface damage will be reduced, to a certain extent.

In an example pyrolithic silicon oxide (Pyrox) was deposited by atmospheric pressure chemical vapor deposition (APCVD). As opposed to conventional thermal oxides, or wet oxides, which are known to be excellent for surface passivation of silicon, pyrox has poor passivation properties and finds its application in microelectronics as an inexpensive and convenient diffusion mask, or dopant source. In fact, it can be deposited at about 400 °C, which means that even low quality silicon material can withstand the deposition process without risk of thermal poisoning.

Thermal annealing can, to some extent, improve the surface passivation quality of pyrox. However, prolonged treatments lead to a degradation of the sample. Moreover, it has been observed that there may be a degradation of the surface passivation qualities with air exposure.

Hydrogenated silicon nitride (SiNx:H) can be used to stably improve the quality of the pyrox/silicon interface. It is known that silicon nitride can lead to excellent surface and bulk passivation properties on silicon, reason for which it is widely used in solar cell technology. However, its application for rear side passivation of an industrial solar cell is not straightforward. There exists an interaction between silicon nitride and metal capping layer (i.e. the back contact of the solar cell), that leads to decreased surface passivation and cell efficiency (it is believed that this interaction is more than a "shunt" effect as described e.g. in Dauwe S., Mittelstädt L., Metz A., Hezel R., "Experimental evidence of parasitic shunting in silicon nitride rear surface passivated solar cells", Prog. Photovolt. Res. Appl., 10 (4), 271-278, (2002) ). Also the nitride recipes which are known to be best at surface passivation cannot withstand high temperature treatments such as the one that takes place during cofiring of the contacts. On the other hand, it is known that hydrogenated silicon nitride can release hydrogen during high temperature annealing treatments.

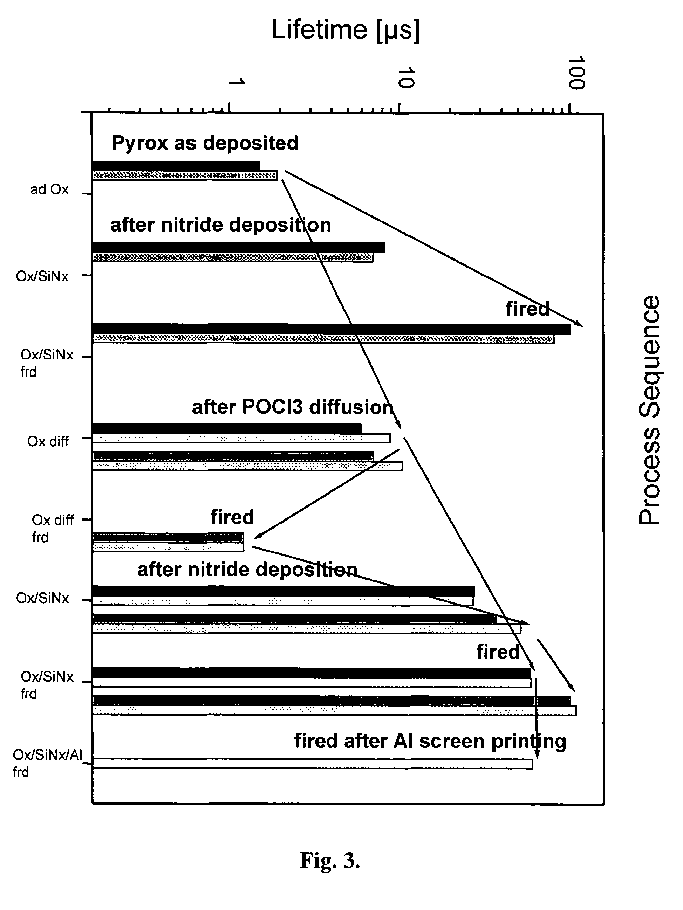

It is believed that the silicon nitride is used as a hydrogen source for the low quality oxide underneath, thereby significantly improving its surface passivation properties. In fig. 3, the trends observed in the effective lifetimes in Cz wafers after different passivation and thermal treatments are shown. Assuming that the bulk lifetime is essentially constant, the effective lifetimes give a direct indication of the quality of surface passivation. The pyrox layer in this experiment was 800 nm thick, excluding any field-induced passivation effect from the overlying silicon nitride, which is in the prior art believed to be the reason for the good passivation quality.

Right after the deposition, the surface passivation quality of the pyrox is very poor. After nitride deposition on top of the pyrox layer there is a limited improvement (red path) and finally when firing the samples, an excellent surface passivation is achieved. Thermal cycles, like e.g. the ones that takes place with POCI3 diffusion (see fig. 3), lead to a limited surface passivation improvement like the one observed after nitride deposition, before firing. Nitride deposition on top of the pyrox and firing, once again, lead to excellent surface passivation (blue path). Firing with or without a metal layer on top lead to the same good results (see the example after Al screen printing in fig. 3). It has been shown that firing alone (without the SiN layer deposition step first) is not beneficial. If firing is applied to the pyrox layer alone, there is a degradation of its surface passivation properties. Nonetheless, these can be recovered by subsequent nitride deposition and firing (green path).

A further advantage of the technique is that since it can be applied to low quality oxides, it can be applied directly on diffusion mask oxides too, greatly simplifying the solar cell process.

Examples of Process sequences

A typical process sequence for surface passivation can comprise the steps of
&#x2022 Chemical cleaning
&#x2022 Low quality oxide deposition (40 to 1500 nm)
&#x2022 Silicon nitride deposition; for instance Low Frequency (450 KHz) direct PECVD Hydrogenated SiNx deposited at 400 degrees from SiH4 and NH3 precursors.
&#x2022 Firing in a three-zone belt furnace, at high belt speed (e.g. more then 100 inch/min), peak set temperature of the furnace up to 960 C° .

This method for surface passivation can be integrated in the process sequence of a solar cell, in different situations:
A) deposition after diffusion
   &#x2022 Front side texturing
   &#x2022 P diffusion resulting in P-doped region all around the substrate
   &#x2022 P-glass removal
   &#x2022 Etching of Si at the rear (sufficient to remove P-doped region at rear)
   &#x2022 Chemical cleaning
   &#x2022 Low quality oxide deposition
   &#x2022 Silicon nitride deposition (rear and possibly front)
   &#x2022 Opening of the local contacts (e.g. by etching paste, scribing or laser ablation)
   &#x2022 Metal deposition (e.g. evaporation, sputtering, screen printing)
   &#x2022 Firing in a commercial belt furnace
B) Before diffusion
   &#x2022 Chemical cleaning
   &#x2022 Low quality oxide deposition
   &#x2022 Diffusion
   &#x2022 Silicon nitride deposition (rear and possibly front)
   &#x2022 Opening of the local contacts (e.g. by etching paste, scribing or laser ablation)
   &#x2022 Metal deposition (e.g. evaporation, sputtering, screen printing)
   &#x2022 Firing in a belt furnace

## Claims

1. Method for the production of a solar cell, comprising the steps of :
i. providing a silicon substrate having a front main surface and a back main surface
ii. depositing a dielectric layer on said back main surface
iii. depositing a passivation layer comprising hydrogenated SiN on top of said dielectric layer
iv. forming holes in said dielectric layer and said SiN:H layer
v. depositing a layer of contacting material onto said dielectric layer, hereby filling said holes.
vi. Applying a high temperature step.

2. Method according to claim 1, wherein said dielectric layer is a low qualitiy dielectric layer or a low quality oxide.

3. Method according to claim 2, wherein said low-quality dielectric layer comprises low quality amorphous silicon oxide

4. Method according to claim 3, wherein said low-quality amorphous oxide is Spin-on oxide or APCVD pyrolithic oxide (pyrox), spin-on, spray-on or dip oxide.

5. Method according to any of the preceding claims, wherein said dielectric layer has a thickness between 40 and 1500 nm.

6. Method according to claim 5, wherein said dielectric layer has a thickness between 800 and 1200 nm.

7. Method according to any of the preceding claims, wherein said high temperature step is a contact firing step and is performed at a temperature higher then 730 degrees Celcius and below 960 degrees Celcius.

8. Method according to any of the preceding claims, wherein the step of forming holes is performed by applying an etching paste, scribing or by laser ablation.

9. Method according to any of the preceding claims, wherein the step of depositing a layer of contacting material is performed by evaporation, sputtering or screen printing.

10. Method according to any of the preceding claims, further comprising a step of diffusion and emitter removal before depositing said dielectric layer.

11. Method according to any of the claims 1 to 9, wherein a step of diffusion is applied after the step of depositing a dielectric layer and before the step of depositing Si:N

12. Method according to claim 11, wherein said dielectric layer is used as a diffusion mask.

13. Method according to any of the preceding claims, wherein said layer of contacting material is discontinuous.

14. Method according to claim 13, wherein during the step of depositing a contacting material, said contacting material is deposited essentially in said holes.

15. Method according to any of the preceding claims, wherein said front main surface has undergone a typical solar cell front surface processing.

16. Method according to any of the preceding claims, further comprising the steps of the method according to any of the preceding claims on the front main surface.

17. Method according to the any of the preceding claims, wherein said silicon substrate is thinner then 250 micron, or thinner then 200 or 150 micron.

18. A solar cell device comprising
i. a silicon substrate having a front main surface and a back main surface
ii. a dielectric layer on said back main surface
iii. a passivation layer comprising hydrogenated SiN on top of said dielectric layer
iv. holes through said dielectric layer and said SiN:H layer
v. layer of contacting material onto said dielectric layer, said layer also filling said holes.

19. Device according to claim 18, wherein said dielectric layer is a low qualitiy dielectric layer or a low quality oxide.

20. Device according to claim 19, wherein said low-quality dielectric layer comprises low quality amorphous silicon oxide.

21. Device according to claim 20, wherein said low-quality amorphous oxide is Spin-on oxide or APCVD pyrolithic oxide (pyrox), spin-on, spray-on or dip oxide.

22. Device according to any of the claims 18 to 21, wherein said dielectric layer has a thickness between 40 and 1500 nm.

23. Device according to claim 22, wherein said dielectric layer has a thickness between 800 and 1200 nm.

24. Device according to any of the claims 18 to 23, wherein said layer of contacting material is discontinuous.

25. Device according to claim 24, wherein said contacting material is present essentially in said holes.

26. Device according to any of the claims 18 to 25, wherein said front main surface also comprises a structure according to any of the claims 18 to 25.

27. Device according to any of the claims 18 to 25, wherein said front main surface comprises a typical solar cell front surface.

28. Device according to any of the claims 18 to 27, wherein said substrate has a thickness smaller then 250 micron or smaller then 200 or 150 micron.
